# EUROPÄISCHE PATENTSCHRIFT

(11) **EP 2 020 061 B1**
(45) Veröffentlichungstag und Bekanntmachung des Hinweises auf die Patenterteilung: **01.12.2010**
(21) Anmeldenummer: 07728956.9
(22) Anmeldetag: 09.05.2007
(51) Int. Cl.: H01S 3/042, G05D 23/19

(54) **VERFAHREN ZUR HOCHPRÄZISEN REGELUNG VON LASTVARIABLEN WÄRMEQUELLEN ODER -SENKEN, INSBESONDERE VON PUMPDIODEN FÜR FESTKÖRPERLASER**
METHOD FOR THE HIGHLY PRECISE REGULATION OF LOAD-VARIABLE HEAT SOURCES OR HEAT SINKS, ESPECIALLY PUMP DIODES FOR SOLID-STATE LASERS
PROCÉDÉ PERMETTANT DE RÉGLER AVEC UNE GRANDE PRÉCISION DES SOURCES OU PUITS DE CHALEUR VARIABLES EN FONCTION DE LA CHARGE, EN PARTICULIER DE DIODES DE POMPE POUR LASERS À SOLIDE

(30) Priorität: 19.05.2006 DE 102006023615
(43) Veröffentlichungstag der Anmeldung: 04.02.2009
(73) Patentinhaber: ARGES Gesellschaft für Industrieplanung und Lasertechnik m.b.H., 92507 Nabburg (DE)
(72) Erfinder: GUGGENMOS, Markus, 92421 Schwandorf (DE); HARTMANN, Martin, 90559 Burgthann (DE)
(74) Vertreter: Meissner, Bolte & Partner
(86) Internationale Anmeldenummer: PCT/EP2007/054504
(87) Internationale Veröffentlichungsnummer: WO 2007/134969

(56) Entgegenhaltungen:
- EP-A2- 0 987 799
- WO-A-00/77456
- US-A1- 2003 127 526
- EL-GENK ET AL: "DynMo-TE: Dynamic simulation model of space reactor power system with thermoelectric converters" NUCLEAR ENGINEERING AND DESIGN, AMSTERDAM, NL, Bd. 236, Nr. 23, Dezember 2006 (2006-12), Seiten 2501-2529, XP005708425 ISSN: 0029-5493

## Beschreibung

Die Beschreibung betrifft ein Verfahren zur hochpräzisen Regelung von lastvariablen Wärmequellen gemäß dem Oberbegriff des unabhängigen Patentanspruchs, sowie eine Einrichtung zur Temperaturführung einer dynamischen Wärmequelle, insbesondere Pumpdioden für Festkörperlaser.

Bei kommerziell erhältlichen Kühl- oder Heizgeräten mit flüssigen Medien wird gemäß dem Stand der Technik durch eine Regelungsvorrichtung ausschließlich die Temperatur des Vorlaufs konstant gehalten. Die Temperatur des Rücklaufs und der Durchfluss durch den angeschlossenen Verbraucher bleiben unberücksichtigt. Verändert sich die thermische Last, wird erst nach einer größeren Zeitspanne, d.h. wenn sich das Kühlmittel innerhalb eines Reservoirs so weit erwärmt hat, dass sich die Vorlauftemperatur ändert, die Heiz- oder Kühlleistung des Systems durch die vorgesehene Regelung an die Lastverhältnisse angepasst. Hierdurch ergibt sich eine vergleichsweise träge Reaktion des Systems auf eine wechselnde Wärmeeinleitung durch die zu temperierende Wärmequelle oder -senke.

Darüber hinaus besteht bei den Lösungen des Standes der Technik eine Abhängigkeit der Ist-Temperatur von den Lastverhältnissen dadurch, dass bei realen Systemen die Wärmequelle oder -senke nicht direkt durch das Kühlmedium selbst temperiert wird, sondern zusätzliche Wärmeübergangswiderstände zwischen Wärmequelle/-senke und den temperierten Medien vorliegen. Hierdurch bedingt verändert sich bei konstanter Vorlauftemperatur die Temperatur an der Wärmequelle oder Wärmesenke lastabhängig.

Einrichtungen zur Temperaturführung von Pumpdioden für Festkörperlaser gehören zum bekannten Stand der Technik (z.B. WO 00/77456A oder EP-A-0 987 799). Bei derartigen bekannten Laserkühlungen wird üblicherweise nur die Vorlauftemperatur geregelt bzw. als Sollwert vorgegeben. Die Rücklauftemperatur ist dabei abhängig von der eingebrachten Wärmemenge sowie vom Wärmefluss, d.h. von dem je Zeiteinheit fließenden Kühlmittel. Weitere Abhängigkeiten liegen aufgrund von Querschnittsveränderungen, z.B. durch Ablagerungen im Kühlmittelkreislauf vor.

Bei mittels Halbleiterdioden gepumpten Festkörperlasern ist eine exakte Abstimmung der Emissionswellenlänge der Pumpdioden auf die Pumpbänder des Laserkristalls einer der entscheidenden Parameter zur Optimierung des Lasergesamtwirkungsgrads. Beispielsweise liegt ein Pumpband von 805 nm bis 809 nm des Nd:YAG-Kristalls im Bereich der Emissionswellenlänge von Galliumarsenid-Dioden, wobei bei einer Pumpwellenlänge von 808 nm die größte Effizienz des Lasersystems erreicht wird.

Da sich bei den Pumpdioden die emittierte Wellenlänge temperaurabhängig um ca. 0,25 nm/K verschiebt, ist eine exakte Steuerung der Emittertemperatur für eine hohe Ausgangsleistungskonstanz des Nd:YAG-Lasers unabdingbar.

Die Abhängigkeit der Wellenlänge von der Temperatur äußert sich darin, dass beispielsweise eine Laserdiode mit Werksangabe 810 nm / 25°C ihren zur Anregung optimalen Wellenlängenbereich von 808 nm bei tatsächlich 17°C erreicht. Es ist daher notwendig, für einen maximalen Wirkungsgrad die exakte Pumpdiodentemperatur durch eine anforderungsgerechte, genau geregelte Kühlung vorzugeben und einzustellen.

Weitere Schwierigkeiten hinsichtlich der gewünschten exakten Pumpdiodentemperatur-Einstellung liegen darin, dass die eingesetzten Laserdioden infolge von Streuungen beim Herstellungsprozess grundsätzlich unterschiedliche diodenspezifische Wellenlängen aufweisen. Werden mehrere derartige Laserdioden zum Pumpen eingesetzt, so enthält das Pumplicht auch spektrale Wellenlängenanteile, welche nur mit einer geringen Effizienz zur Anregung des Laserkristalls genutzt werden können.

Aus dem Vorgenannten ist es daher Aufgabe der Erfindung, ein weiterentwickeltes Verfahren zur hochpräzisen Regelung von lastvariablen Wärmequellen oder -senken sowie eine zugehörige Einrichtung zur Temperaturführung anzugeben, wobei eine hohe Regelungsgenauigkeit mit entsprechendem zügigen Anssprechverhalten gewährleistet ist, so dass insgesamt ein optimiertes Wärme- und Kältemanagement erreicht werden kann.

Die Lösung der Aufgabe der Erfindung erfolgt mit einem Verfahren gemäß der Lehre nach Patentanspruch 1, wobei die Unteransprüche mindestens zweckmäßige Ausgestaltungen und Weiterbildungen darstellen.

In einer ersten verfahrensseitigen Umsetzung der erfindungsgemäßen Lehre wird für die Regelung ein rechnerischer Mittelwert aus Vorlauf- und Rücklauftemperatur als Ist-Weit verwendet. Hierdurch lässt sich bereits ohne zusätzliche Informationen über die Art der thermischen Last und die abzuführende Wärmemenge die Stabilisierung der Wärmequelle verbessern.

Ein Vorteil liegt hierin begründet, dass die mittlere Bezugstemperatur T_{M} = 1/2 · (T v + T_{R}) für den Wärmefluss Q_{L} unabhängig von der abzuführenden Wärmemenge auf einem konstanten Weit gehalten wird. Somit fühlt eine Erhöhung des Wärmeflusses zur eigentlichen Kühleinrichtung automatisch zu einer Absenkung der Vorlauftemperatur. Da sich bei einem Lastwechsel die Rücklauftemperatur rascher als die Reservoirtemperatur ändert, spricht die Regelung in der gewünschten Weise auch schneller an. Bei der vorgeschlagenen Mittelwertregelung findet der Wärmeübergangswiderstand zwischen Wärmequelle (z.B. einer Laserdiode) und Wärmesenke (z.B. dem Kühlwasser) noch keine Berücksichtigung. Bei einer realen Applikation bedeutet dies, dass die Temperatur der Wärmequelle immer noch lastabhängig linear mit zunehmendem Wärmefluss zunimmt. Ist der Wärmewiderstand zwischen der Wärmequelle und der Wärmesenke bekannt, so lässt sich dies verfahrensgemäß berücksichtigen, wenn der Wärmefluss, d.h. die Kühlleistung in den Kühler einer messtechnischen Erfassung unterliegt.

Bei einem weiteren verfahrensgemäßen Gedanken wird auf eine Mittelwertregelung unter Berücksichtigung des tatsächlichen Wärmeflusses durch die Temperiervorrichtung zurückgegriffen.

Mit einem Durchflusssensor und aus den Messwerten Vorlauflemperatur T ᵥ und Rücklauftemperatur T _{R} lässt sich die Kühlleistung (Wärmefluss) Q_{K} = (T_{V} - T_{R}) · Vdt · k des Kühlgeräts bestimmen. Vdt stellt hier den Volumenfluss dar.

Da in einem geschlossenen System im stationären Fall bei sich nicht verändernden Temperaturen die Summe aller Wärmeflüsse Null ist, gilt unter Vernachlässigung der Strahlungsverluste Q_{S}, dass die abgegebene Wärmeleistung der Wärmequelle gleich der Kühlleistung des Kühlgeräts ist, d.h. Q_{K} = Q_{L}. Für einen konstanten Wärmeleitungswidersland R_{WL} zwischen der Wärmequelle und dem Kühlkreis ergibt sich somit eine zum Wärmefluss proportionale Temperaturdifferenz. Im Umkehrschluss ist für jeden Wärmefluss unter Berücksichtigung des Wärmeleitungswiderstands R_{WL} ein Korrekturwert für die mittlere Bezugstemperatur T _{M} berechenbar, welche eingestellt werden muss, um die Temperatur der Last T_{Q.S} unter den gemessenen Lastbedingungen konstant zu halten. Wenn es in der Praxis nicht möglich ist, den Wärmewiderstand zwischen Wärmequelle und Wärmesenke direkt zu bestimmen, kann aufgrund der linearen Zusammenhänge der für die Modellrechnung benötigte Wärmeübergangswidersund empirisch durch manuelle Optimierung des Systems an zwei Betriebspunkten, z.B. bei 40% und bei 90% Last bestimmt werden.

Eine weitere verfahrensseitige Realisierung der Erfindung besteht in der Mittelwertregelung unter Berücksichtigung des tatsächlichen Wärmeflusses durch die Temperiervorrichtung und die Störgröße Q_{S}.

Im Falle einer zu temperierenden Laserdiode ist es bei hohen Ansprüchen an die Regelungsgenauigkeit notwendig, den Wärmefluss durch die Abstrahlung von elektromagnetischer Strahlung im Modell zu berücksichtigen. Der Wärmefluss durch die optische Abstrahlung kann nämlich bis zu 40% der eingebrachten elektrischen Leistung betragen. Diese Kennlinienberücksichtigung kann entweder im Modell rechnerisch erfolgen oder es besteht die Möglichkeit, die optische Strahlungsleistung als zusätzliche Größe messtechnisch zu erfassen. Hier resultiert der Vorteil, dass eine Alterung der Laserdiode automatisch kompensiert werden kann, da sich mit der Alterung der Wirkungsgrad der Diode verschlechtert und sich das Verhältnis zwischen elektrischer Eingangsleistung und optischer Ausgangsleistung verschiebt. Bei einer entsprechenden Kennliniendarstellung ist dies gleichbedeutend mit einer Verringerung der Geradensteigung.

Es lässt sich an dieser Stelle der verfahrensseitige als auch der in der Einrichtung repräsentierte Grundgedanke der Erfindung darin zusammenfassen, dass zur exakten Regelung einer Laserstrahl-Quellentemperatur neben der Kühlkreis-Vorlauffemperaur auch die Rücklauftemperaur erfasst wird, um hierauf gestützt eine Mittelwertregelung aufzubauen, welche optional den tatsächlichen Wärmefluss und/oder mehrere Störgrößen in der Regelung modellmäßig berücksichtigt. Dies kann mit Hilfe von Korrekturfaktoren im Sinne einer Verschiebung des erwähnten Mittelwerts proportional zur Differenz aus Vor- und Rücklauf erfolgen.

Im Ergebnis durchgeführter Untersuchungen hat es sich in überraschender Weise gezeigt, dass es nicht primär auf die Erfassung absoluter Temperaturen im Vor- und Rücklauf, sondern vielmehr auf den Gradienten, d.h. den Temperaturunterschied zwischen Vor- und Rücklauf ankommt. Werden die hier vorliegenden Gradienten im Betrieb des Lasers erfasst, kann regelungstechnisch außerordentlich zügig reagiert werden, so dass über die räumliche Ausdehnung eines vorhandenen Kühlblocks, auf dem sich eine vorgegebene Anzahl von Pumpdioden befindet, die Temperaturvarianz im Vergleich zum Stand der Technik gering gehalten werden kann. Hierdurch ergibt sich letztendlich die Möglichkeit, einzelne Pumpdioden in einem Temperaturregime zu halten, das für eine optimale Anregung, insbesondere für High-Power-Anwendungen geeignet ist. Die Einrichtung zur Temperaturführung von auf einem Kühlblock angeordneten Pumpdioden für Festkörperlaser besitzt demnach im Pumpdioden-Kühlmittelkreislauf eine Vorlauflemperatur-Messeinrichtung und zusätzlich eine Temperatur-Messeinrichtung, die im Rücklauf angeordnet ist. Optional kann eine Durchfluss-Messeinrichtung für das Kühlmittel eingesetzt werden, um den sächlichen Wärmefluss zu bestimmen.

Die Vorlauf- und Rücklauftemperastur-Messeinrichtungen stehen mit einer, auch analogen, Recheneinheit in Verbindung, welche die bereits erwähnte Mittelwertbildung vornimmt, um einen Kälteleistungsvorgabewert zu ermitteln, welcher Schalteinrichtungen oder Ventilen zur Leistungsregelung, die sich im Kältemittelkreislauf befinden, übergeben wird.

Die Vorlauf- und/oder Rücklauftemperatur-Messeinrichtung kann bei einer Ausgestaltung als Temperaturdifferenzsensor ausgebildet sein.

Der Kältemittelkreislauf kann mit einem Durchflusssensor zur Ermittlung des Wärmeflusses aus Temperaturdifferenz und Vorlauf- bzw. Rücklauftemperatur versehen sein. Kältespezifisch wird der Wärmeübergang zwischen den Pumpdioden und dem Material eines Pumpdioden-Kühlblocks ermittelt und dieser Wert als Korrekturfaktor K1 der Recheneinheit übergeben. Die diodenspezifische Wärmeabstrahlung über die jeweilige Pumpenleistung wird ebenfalls ermittelt. Diese Abhängigkeit wird dann als zweiter Korrekturfaktor K2 oder als Korrekturfunktion f(K2) der Recheneinheit übergeben.

In Abhängigkeit von den jeweils aktuellen Mittelwerten fühlt die Recheneinheit aus dem sich hieraus mittelbar ergebenden Leistungsumsatz der Umwälzpumpe im Kuhlmittelkreislauf ein Steuersignal zu.

Optional besteht die Möglichkeit, in einem im Kühlmittelkreislauf befindlichen Kühlmittelvorratsbehälter eine Hcizcinrichtung vorzusehen, um vom kuhlmittelkreislauf eine nahezu konstante Kälteleistung auch bei an sich unterschiedlichen Anforderungen, die vom eigentlichen Laser herrühren, abzufordern.

Die Erfindung soll nachstehen anhand von Ausführungsbeispielen sowie unter Zuhilfenahme von Figuren näher erläutert werden.

Hierbei zeigen:

Fig. 1 eine Prinzipdarstellung zum Verständnis der Modellbetrachtung des erfindungsgemäßen Regelverfahrens und

Fig. 2 eine Prinzipdarstellung einer Einrichtung zur Temperaturführung, umfassend einen Pumpdioden-Kühlmittelkreislauf (Wasserkreislauf) und einen Kältekreislauf.

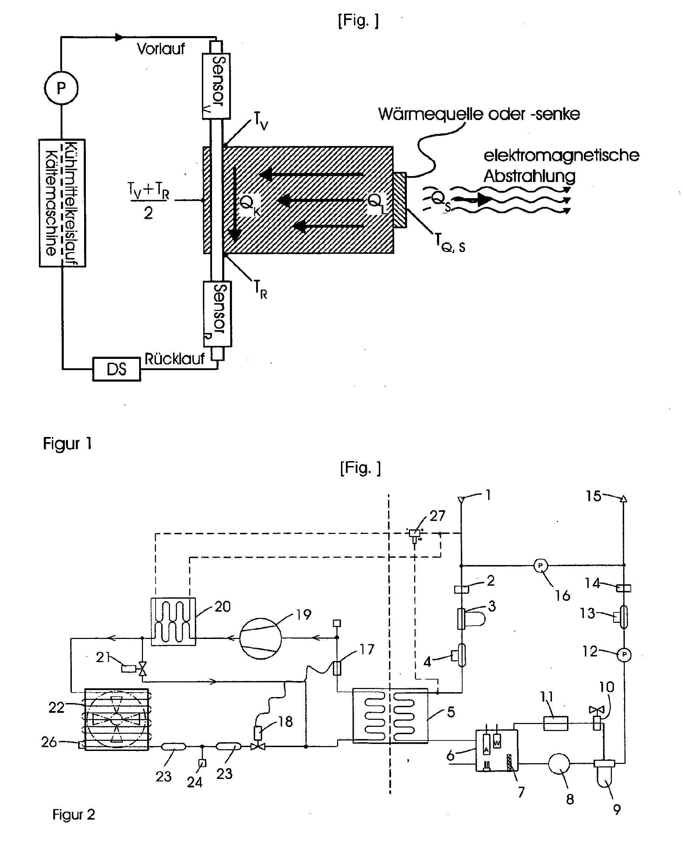

Die Darstellung nach Fig. 1, nämlich das Modell eine flüssigkeitsgefühiten Systems mit Strahlungsverlusten, zeigt eine Wärmequelle oder -senke mit angedeuteter elektromagnetischer Abstrahlung.

Diese Wärmequelle kann eine oder eine Gruppe von Laserdioden umfassen. Mit T_{Q}. s ist die Ist-Temperatur von Wärmequelle bzw. -senke bezeichnet. Q_{S} repräsentiert den Wärmefluss durch elektromagnetische Be- oder Abstrahlung und weiterer Störgrößen. Q_{L} bezeichnet den Wärmefluss zum / vom temperierenden Medium und Q_{K} den Wärmefluss des Kühlers. Im Vorlauf und im Rücklauf sind entsprechende Temperdursensofen V und R vorhanden.

Bezogen auf die Modelldarstellung gelten folgende physikalische Zusammenhänge:

Die Summe aller Wärmeflüsse des gesamten Systems ist im statischen Fall Null, d.h. Q_{K}+Q_{L}+Q_{S}=0.

Der Wärmefluss des Kühlerkreises ist durch das Produkt der Temperaturdifferenz T v - T_{R} und der Durchflussmenge des Mediums sowie der Wärmekapazität k des Mediums bestimmt, d.h. es ergibt sich Q_{K} ∼ (T_{V} - T_{R}) . Vdt · k.

Der Wärmefluss Q_{L} aus der oder in die Wärmesenke ist proportional zur Temperaturdifferenz T_{QS} - T_{M} und dem Wärmeleitungswiderstind R_{WL} zwischen Wärmequelle / -senke und Temperierkreis, d.h. Q_{L} ∼ T_{QS} - (T_{V} - T_{R})/2 · R_{WL}.

Eine Störgröße Q_{S} kann den Wärmefluss von Q_{L} vergrößern oder verkleinern und entweder als Konstante vernachlässigt werden, durch eine Kennlinie beschrieben oder messtechnisch erfasst werden.

Mit Blick auf diese grundsätzlichen Überlegungen lassen sich verschiedene Stufen hinsichtlich der Genauigkeit der Temperierung einer Last realisieren.

Zunächst besteht die Möglichkeit, dass die Regelung den rechnerischen Mittelwert der Temperatur stabilisiert, welche aus den Sensoren für die Vorlauf- und Rücklauftemperatur erhalten wird. Hier ergibt sich der Vorteil, dass ohne zusätzliche Informationen über die Art der Last eine Stabilisierung der Lasttemperatur möglich ist, da die mittlere Bezugstemperatur T_{M} für den Wärmefluss Q_{L} unabhängig von der Last auf einem konstanten Weit gehalten wird.

Mit einem Durchflusssensor DS und unter Beachtung der Messwerte aus T_{V} und T_{R} kann der zusätzliche Wärmefluss in die oder aus der Temperiervorrichtung berechnet werden. Aus dem so bestimmten Wärmefluss wird ein Korrekturwert für die mittlere Bezugstemperatur T_{M} unter Berücksichtigung des Wärmeübergangswiderstands R_{WL} errechnet, welcher einzustellen ist, um die Temperatur der Last T_{Q.S} unter den gemessenen Lastbedingungen konstant zu halten. Die Bestimmung des für die Modellrechnung benötigten Wärmeübergangswidersunds lässt sich z.B. durch eine manuelle Optimierung an zwei Betriebspunkten des jeweiligen Systems vollziehen.

Eine weitere Verbesserung des Verfahrens nebst Erhöhung der Regelungsgenauigkeit ist dadurch möglich, wenn bezüglich der Störgröße Q_{S} eine Abhängigkeit von der Last berücksichtigt wird. Im Falle einer optischen Sendediode kann dies die Kennlinienstrahlungsleistung in Abhängigkeit von der elektrischen Eingangsleistung sein, welche messtechnisch in einfacher Weise erfassbar ist.

Die Fig. 2 zeigt eine Prinzipdarstellung einer Einrichtung zur Temperaturführung an einer dynamischen Wärmequelle, hier insbesondere von Pumpdioden für Festkörperlaser, umfassend einen Pumpdioden- Kühlmittelkreislauf sowie einen an diesen Kreislauf über einen Wärmetauscher gekoppelten Kältemittelkreislauf. Der Rücklauf 1 des in der Fig. 2 nicht dargestellten Lasers weist einen Temperaturfühler 2 z.B. in Form eines Thermoelements auf.

In Reihenschaltung befinden sich ein erstes Wasserfilter 3 und eine erste Durchflussmessturbine 4. Ausgangsseitig der Durchflussmessturbine 4 ist ein Wärmetauscher, z.B. ausgeführt als Plattenverdampfer 5, vorgesehen.

Dieser Plattenverdampfer 5 steht mit einem Kühlmittelvorratstank 6 in Verbindung.

Neben verschiedenen Messeinrichtungen weist der Kühlmilttelvorratstank 6 eine im Tankinneren befindliche Tankheizung 7 auf.

Ausgangsseitig des Tanks ist eine Umwälzpumpe 8 (in Fig. 1 mit P bezeichnet) vorhanden, die auf ein zweites Wasserfilter 9 führt.

Mittels eines Ventils 10 und einer Feinfilterpatrone 11 kann bezogen auf einen entsprechenden Anschluss am Wasserfilter 9 auch ein Bypass geschaltet werden.

Im Vorlaufzweig befindet sich hinter dem zweiten Filter 9 bei einer Ausführungsform ein Drucksensor 12, dem eine zweite Durchflussmessturbine 13 nachgeschaltet ist.

Ausgangsseitig der zweiten Durchflussmessturbine 13 ist eine Vorlauftemperaur-Messeinrichtung 14, wiederum bevorzugt ausgeführt als Thermoelement, angeordnet.

Vorlauf 15 und Rücklauf 1 können über ein Überdruckventil 16, das optional vorgesehen ist, kurzgeschlossen werden.

Der sich am Stand der Technik orientierende Kältemittelkreislauf umfasst ausgehend vom Platenverdampfer 5 zunächst einen Kühler 17 für ein steuerbares Expansionsventil 18.

Ein Kompressor 19 fühlt ausgangsseitig auf einen weiteren Platenverdampfer 20, an dessen Ausgang einerseits ein Ventil 21 und andererseits ein Kondensatorblock 22 angeschlossen ist.

Mit Hilfe des Ventils 21 können Kurzschlussverbindungen des Ausgangs des Kompressors 19 zum Eingang des Plattenverdampfers 5 hergestellt werden. Der Kondensatorblock 22 besitzt an seinem Ausgang eine Trockeneinrichtung 23, welcher ein Druckwächter 24 nachgeschaltet ist.

Über einen Sammler 25 ist eine Verbindung zum Expansionsventil 18 vorgesehen, dessen Ausgang wiederum zum Platenverdampfer 5 führt.

Zur Erfassung der Temperatur des Kondensatorblocks 22 weist dieser einen Temperaturfühler 26 auf.

Der Plattenverdampfer 20 kann über ein Drei-Wege-Ventil 27 mit der Rücklaufseite des Wasserkreislaufs lastanhängig in Verbindung stehen.

Mit Hilfe der im Ausführungsbeispiel geschilderten Einrichtung ist es möglich, eine exakte Temperaturführung einer Pumpstrahlungsquelle zu erreichen sowie in Abhängigkeit von Laserleistung und Lasertyp Störeinflüsse, wie sie bei bekannten Laserregelungen auftreten, zu eliminieren.

Da die Ankopplung der Pumpdioden an den in der Fig. 2 nicht dargestellten Kühlblock einen nicht zu vernachlässigenden Einfluss auf das Regelverhalten hat, wird geräte- bzw. anlagenspezifisch eine Verschiebung des Mittelwerts durch den erwähnten Korrekturfaktor mit Blick auf das erfindungsgemäße Verfahren vorgenommen, wobei hier auch bei einem längeren Betrieb eintretende Veränderungen, z.B. durch Alterung des Wärmeübemragungs- bzw. Koppelmaterials im Regelkonzept berücksichtigt werden können.

Im Sinne der Reproduzierbarkeit können optimierte Kühlblöcke, quasi als Standard-Baugruppe eingesetzt werden, wobei für die jeweiligen Baugruppen die Ankoppelungsgüte zwischen Wärmesenke (Kühler) und Wärmequelle (Laserdiode) vorbekannt ist, um die Mittelwertverschiebung mittels Korrekturfaktor zu vereinfachen.

Bezugszeichenliste
- 1: Rücklauf
- 2: Temperaturfühlerrücklauf
- 3: erster Wasserfilter
- 4: erste Durchflussmessturbine
- 5: Platenverdampfer
- 6: Kühlmittelvorratsbehälter
- 7: Tankheizung
- 8: Pumpe
- 9: zweites Wasserfilter
- 10: Ventil
- 11: Feinfilterpatrone
- 12: Drucksensor
- 13: zweite Durchflussmessturbine
- 14: Temperaursensorvorlauf
- 15: Vorlauf
- 16: Überdruckventil
- 17: Fühler für Expansionsventil
- 18: Expansionsventil
- 19: Kompressor
- 20: Plattenverdampfer
- 21: Ventil
- 22: Kondensatorblock
- 23: Trockeneinrichtung
- 24: Druckwächter
- 25: Sammler
- 26: Temperaturfühler
- 27: Drei-Wege-Ventil
- P: Pumpe
- DS: Durchflusssensor
- T_{V}: Vorlauftemperatur
- T_{R}: Rücklauftemperatur
- T_{M}: Mittelwert (T_{V} + T_{R})/2
- Vdt: Volumenfluss
- Q_{K}: Wärmefluss Kühler
- T_{Q.S}: Ist-Temperatur der Wärmequelle oder -senke
- Q_{L}: Wärmefluss zum / vom temperierenden Medium
- Q_{S}: Wärmefluss durch Abstrahlung oder weitere Störgrößen

## Patentansprüche

1. Verfahren zur hochpräzisen Regelung von lastvariablen mit einem Kühlmittelkreislauf versehenen Wärmequellen, insbesondere zur Regelung von Pumpdioden für Festkörperlaser,
umfassend einen ersten Verfahrensschritt wonach ein rechnerischer Mittelwert (T_{M}) aus Kühlmittelkreisvorlauf (T_{V}) - und Kühlmittelkreisrücklauftemperatur (T_{R}) als Ist-Wert zur Kältelleistungsregelung vorgegebenen wird, wobei der rechnerische Mittelwert (T_{M}) als eine mittlere Bezugstemperatur für einen Wärmefluss (Q_{L}) zur Wärmequelle bzw. von der Wärmequelle unabhängig von einer abzuführenden Wärmemenge betrachtet und mittels Regelung des Kühlmittelkreislaufes auf einem konstanten Wert gehalten wird,
**dadurch gekennzeichnet, dass**
in einem weiteren Verfahrensschritt mittels Durchflussbestimmung des Volumenstroms eines Kühlmittels im Kühlmittelkreislauf sowie Kühlmittelkreisvor (T_{V}) und -rücklauftemperatur (T_{R}) ein tatsächlicher Wärmefluss zur Wärmequelle bzw. von der Wärmequelle berechnet wird, um hieraus einen Korrekturfaktor für die mittlere Bezugstemperatur unter Berücksichtigung eines Wärmeübergangswiderstands (R_{WL}) zwischen Wärmequelle und Kühlmittelkreislauf zu ermitteln, welcher einen Vorgabewert darstellt, um die Temperatur der Last unter bestimmten Lastbedingungen mittels Regelung des Kühlmittelkreislaufes konstant halten zu können, wobei
zur Erhöhung der Regelungsgenauigkeit lastabhängige Störgrößen (Q_{S}) erfasst und bei der Bestimmung des Vorgabewertes für die Regelung berücksichtigt werden.

2. Verfahren nach Anspruch 1,
**dadurch gekennzeichnet, dass**
mittels Messeinrichtungen die Kühlmittelkreislaufvorlauftemperatur und der Kühlmittelkreislaufrücklauftemperatur erfasst werden und die ermittelten Temperaturwerte an eine analoge oder digitale Recheneinheit weitergeben werden, welche eine Mittelwertbildung vornimmt, um einen Kälteleistungs-Vorgabewert zu ermitteln, welcher an vorgesehene Schalteinrichtungen zur Kälteleistungsregelung übergeben wird, wobei
gerätespezifisch der Wärmeübergang zwischen den Pumpdioden und einem im Kühlmittelkreislauf vorgesehenen Pumpdioden-Kühlblocks ermittelt und dieser als erster Korrekturfaktor (K1) der Recheneinheit übergeben wird.

3. Verfahren nach Anspruch 2,
**dadurch gekennzeichnet, dass**
die pumpdiodenspezifische Wärmeabstrahlung über die jeweilige Pumpleistung ermittelt und diese Abhängigkeit als zweiter Korrekturfaktor (K2) oder als Korrekturfunktion (f(K2)) der Recheneinheit übergeben wird.

4. Verfahren nach Anspruch 2 oder 3,
**dadurch gekennzeichnet, dass**
in Abhängigkeit von einem jeweiligen aktuellen Mittelwert die Recheneinheit aus dem sich hieraus mittelbar ergebenden Leistungsumsatz einer im Kühlmittelkreislauf befindlichen Umwälzpumpe ein Steuersignal zuführt.

## Claims

1. Method for the highly precise regulation of load-variable heat sources provided with a coolant circuit, especially for the regulation of pump diodes for solid-state lasers,
comprising a first method step according to which a calculated mean value (T_{M}) of the coolant circuit forward flow temperature (T_{V}) and the coolant circuit return flow temperature (T_{R}) is preset as an actual value for regulating the refrigerating capacity, wherein the calculated mean value (T_{M}) is considered as a mean reference temperature for a heat flow (Q_{L}) to the heat source or from the heat source irrespective of a heat quantity to be dissipated and is maintained at a constant value by the regulation of the coolant circuit,
**characterized in that**
by means of a flow determination of the volume flow of a coolant in the coolant circuit and the coolant circuit forward flow temperature (T_{V}) and return flow temperature (T_{R}) an actual heat flow to the heat source and from the heat source is calculated in another method step in order to determine from these a correction factor for the mean reference temperature with consideration of a heat transmission resistance (R_{WL}) between the heat source and the coolant circuit, which represents a default value for allowing to maintain the temperature of the load constant under certain load conditions by the regulation of the coolant circuit, wherein
for increasing the regulation accuracy, load-dependent disturbance variables (Q_{S}) are detected and taken into account in the determination of the default value for the regulation.

2. Method according to claim 1,
**characterized in that**
the coolant circuit forward flow temperature and the coolant circuit return flow temperature are detected by measuring devices and the detected temperature values are transferred to an analog or digital computing unit, which performs an averaging in order to determine a refrigerating capacity default value which is transmitted to provided switching devices for the regulation of the refrigerating capacity,
wherein
the heat transfer between the pump diodes and a pump diode cooling block provided in the coolant circuit is determined on a device-specific basis and is transferred to the computing unit as a first correction factor (K1).

3. Method according to claim 2,
**characterized in that**
the pump diode-specific heat radiation is determined over the respective pump performance and this dependency is transferred to the computing unit as a second correction factor (K2) or as a correction function (f(K2)).

4. Method according to claim 2 or 3,
**characterized in that**
as a function of a respective current mean value and the capacity turnover indirectly resulting from therefrom, the computing unit transmits a control signal to a circulating pump located in the coolant circuit.

## Revendications

1. Procédé pour la régulation à haute précision de sources de chaleur à charge variable dotées d'un circuit de refroidissement, en particulier pour la régulation de diodes-pompes pour lasers à corps solide,
comprenant une première étape de procédé selon laquelle on impose une valeur moyenne calculée (T_{M}) formée à partir de la température d'entrée dans le circuit de refroidissement (T_{V}) et de la température de retour du circuit de refroidissement (T_{R}) à titre de valeur réelle pour la régulation de la puissance de refroidissement, dans lequel la valeur moyenne calculée (T_{M}) est considérée comme étant une température de référence moyenne pour un flux de chaleur (Q_{L}) vers la source de chaleur ou respectivement provenant de la source de chaleur indépendamment d'une quantité de chaleur à évacuer et est maintenue à une valeur constante au moyen d'une régulation du circuit de refroidissement,
**caractérisé en ce que**
dans une autre étape de procédé, au moyen d'une détermination de débit du courant volumétrique d'un agent de refroidissement dans le circuit de refroidissement ainsi que de la température d'entrée dans le circuit de refroidissement (T_{V}) et de la température de retour du circuit de refroidissement (T_{R}), on calcule un flux thermique effectif vers la source de chaleur ou respectivement depuis la source de chaleur, afin de déterminer à partir de celui-ci un facteur de correction pour la température de référence moyenne en tenant compte d'une résistance de transition thermique (R_{ωL}) entre la source de chaleur et le circuit de refroidissement, résistance qui représente une valeur imposée afin de pouvoir maintenir constante la température de la charge sous certaines conditions de charge au moyen d'une régulation du circuit de refroidissement, dans lequel
pour augmenter l'exactitude de la régulation, on détecte des grandeurs perturbatrices (Q_{S}) qui dépendent de la charge et on les prend en compte lors de la détermination de la valeur imposée pour la régulation.

2. Procédé selon la revendication 1,
**caractérisé en ce que** l'on détecte la température d'entrée du circuit de refroidissement et la température de retour du circuit de refroidissement au moyen de systèmes de mesure, et les valeurs de température déterminées sont transmises à une unité de calcul analogique ou numérique, qui procède à la formation d'une valeur moyenne afin de déterminer une valeur imposée pour la puissance de refroidissement, laquelle est transmise à des dispositifs de commutation prévus pour la régulation de la puissance de refroidissement, et
le transfert thermique entre les pompes-diodes et un bloc de refroidissement de pompes-diodes prévu dans le circuit de refroidissement est déterminé de manière spécifique à l'appareil, et celui-ci est transmis à l'unité de calcul à titre de premier facteur de correction (K1).

3. Procédé selon la revendication 2,
**caractérisé en ce que** le rayonnement thermique spécifique à la pompe-diode est déterminé en fonction de la puissance de pompage respective et celui-ci est transmis à l'unité de calcul à titre de second facteur de correction (K2) ou à titre de fonction de correction (f(K2)).

4. Procédé selon la revendication 2 ou 3,
**caractérisé en ce que** l'unité de calcul fournit un signal de commande à une pompe de recirculation qui se trouve dans le circuit de refroidissement, en fonction d'une valeur moyenne respective actuelle, à partir du bilan de puissance résultant indirectement de celle-ci.
